# EUROPEAN PATENT APPLICATION

(11) **EP 4 622 406 A1**
(43) Date of publication of application: **24.09.2025**
(21) Application number: 25163135.4
(22) Date of filing: 12.03.2025
(51) Int. Cl.: H05K 3/24, H05K 3/40, H05K 1/11, H05K 3/18

(54) **A COMPONENT CARRIER AND A METHOD OF MANUFACTURING THE COMPONENT CARRIER**

(30) Priority: 21.03.2024 CN 202410327211
(71) Applicant: AT&S (Chongqing) Company Limited, Chongqing 401133 (CN)
(72) Inventor: NG, Shawn, 12300 Butterworth, Penang (MY); ZHOU, Max, Chongqing, 400063 (CN); DANG, Roc, Chongqing, 400000 (CN)
(74) Representative: Donatello, Daniele

(57) **Abstract**

The invention relates to a component carrier (100) and a method of manufacturing the component carrier (100). The component carrier (100) comprises : i) a first exposed conductor area (110), comprising a first protective layer structure (111) on a first electrically conductive layer structure (112); and ii) a second exposed conductor area (120), comprising a second protective layer structure (121) on a second electrically conductive layer structure (122). The first protective layer structure (111) and the second protective layer structure (121) comprise: a) a common non-exposed layer structure (130); and b) different exposed layer structures (133, 140).

## Description

### Field of the Invention

The invention relates to a component carrier, comprising a first exposed conductor area, comprising a first protective layer structure on a first electrically conductive layer structure, and a second exposed conductor area, comprising a second protective layer structure on a second electrically conductive layer structure. The first protective layer structure and the second protective layer structure comprise: a common non-exposed layer structure, and different exposed layer structures. Further, a method to manufacture the component carrier is described.

Accordingly, the invention may relate to the technical field of component carriers, such as printed circuit boards or IC substrates, and their manufacture, in particular with respect to surface protection.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

In particular, providing an efficient and robust surface protection (also termed surface finish) for exposed electrically conductive layer structures may be seen as a challenge.

After having completed formation of a stack of electrically insulating layer structures and electrically conductive layer structures in the component carrier manufacture, it is possible to proceed with a surface treatment of the obtained layers structures or component carrier.

In particular, an electrically insulating solder resist (layer structure) may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Further, surface finish can have the advantage of being robust to repeated plugging and unplugging.

Examples for appropriate materials for a surface finish are Organic Solderability Preservative (OSP), Electroless Nickel Immersion Gold (ENIG), Electroless Nickel Immersion Palladium Immersion Gold (ENIPIG) or Electroless Nickel Electroless Palladium Immersion Gold (ENEPIG), gold (in particular hard/plated gold), chemical tin, nickel-gold, nickel-palladium, etc.

In some applications, two or more different surface finishes (for example ENEPIG (in the present context the term ENEPIG can also include ENIPIG) and plated gold) should be applied to different exposed electrically conductive layer structures.

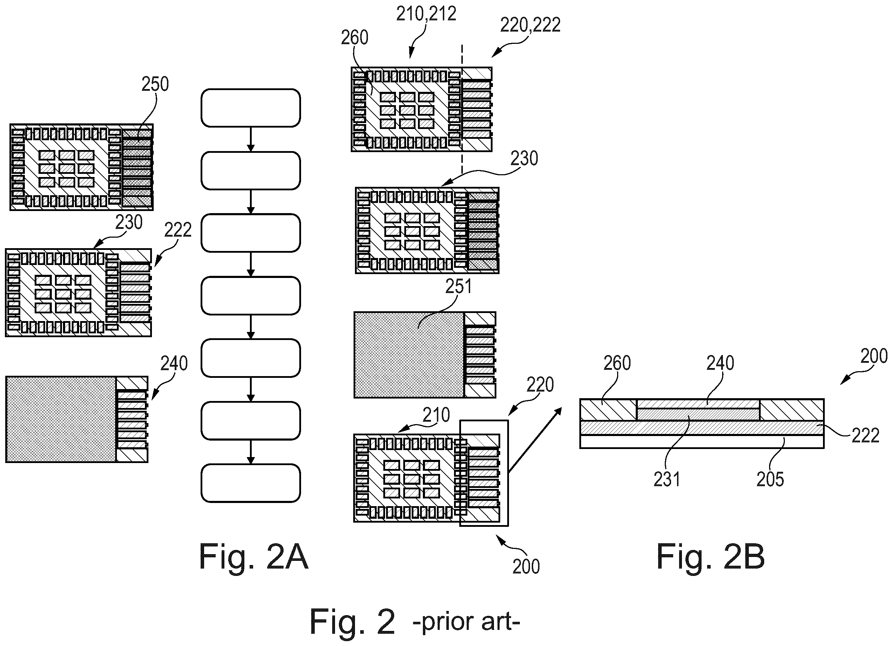

**Figure 2A** shows a conventional example from a component carrier manufacture process with two different surface finishes. Two different surface finishes are needed here to satisfy the requirement of wire bonding and pluggable function at in the assembly. Specifically, first electrically conductive layer structures on the left side should be covered by ENEPIG, while second electrically conductive layer structures on the right side should be covered by plated gold in order to provide a so-called goldfinger-structure (e.g. as electric contacts of a USB-stick).

In the first place, there is provided a component carrier preform with first exposed conductor area 210, comprising a first electrically conductive layer structure 212, and a second exposed conductor area 220, comprising a second electrically conductive layer structure 222. The first electrically conductive layer structure 212 and the second electrically conductive layer structure 222 are covered by a solder resist layer 260. Said solder resist layer 260 comprises openings to expose the first electrically conductive layer structure 212 and the second electrically conductive layer structure 222.

Then, a first protective film (dry film) 250 is applied to selectively cover the second exposed conductor area 220. While the second exposed conductor area 220 is protected, the first exposed conductor area 210 is selectively covered by an ENEPIG surface finish 230.

The first protective film 250 is stripped from the second exposed conductor area 220, and a second protective (dry) film 251 is applied to selectively cover the first exposed conductor area 210. While the first exposed conductor area 210 is protected, the second exposed conductor area 220 is selectively covered by nickel and/or gold plating as surface finish 240. Finally, the second protective film 251 is stripped from the first exposed conductor area 210 to provide the final component carrier 200.

**Figure 2B** shows a cross-section of the component carrier 200 produced by the process described above at the second exposed conductor area 220. The second electrically conductive layer structure 222 (e.g. patterned copper layer) is arranged on an electrically insulating stack material, e.g. prepreg, layer 205. There might be further electrically conductive layer structures and/or further electrically insulating layer structures beneath. On top of the second electrically conductive layer structure 222, there is arranged a solder resist layer structure 260 that comprises said opening for exposing the second electrically conductive layer structure 222 arranged below the solder resist layer structure 260. The exposed second electrically conductive layer structure 222 is covered here by a first layer of plated nickel 231 and a second layer of plated gold 240, the latter being flush with the solder resist layer structure 260 surface. The exposed first electrically conductive layer structure 212 would be covered instead by an ENEPIG structure 230 in this example (not shown in detail).

In a specific example, the plating nickel layer comprises a thickness in the range 2 to 5 µm, while the plating gold layer comprises a thickness larger than 0.5 µm.

Nevertheless, this procedure is cost-intensive and cumbersome, since two (expensive) dry films have to be applied. Application of the dry film actually comprises the steps: dry film laminate, dry film exposure, dry film developing, and dry film stripping. Since the procedure is quite long, there may be a high risk of (nickel) corrosion. Additionally since there is no palladium layer between the nickel and gold, there may be risk of copper immigration to gold layer. That means it impacts the soldering performance and electrical transmission quality. Beside that, palladium can be a promoter to improve the adhesion between nickel and gold. If no palladium layer, there may be crack or delamination of the IMC layer, which also impact the soldering performance and even impact the reliability of the product.

### Summary of the Invention

There may be a need to provide a surface protection for exposed electrically conductive layer structures of a component carrier in an (cost-) efficient and robust manner.

A component carrier and a method of manufacturing are described.

According to a first aspect of the invention, there is described a component carrier (e.g. a printed circuit board, an IC substrate, or an organic interposer), comprising:
i) a first exposed conductor area, comprising a first protective layer structure (in particular comprising immersion metal) on a first electrically conductive layer structure (e.g. first copper traces), and
ii) a second exposed conductor area, comprising a second protective layer structure (in particular comprising immersion metal and plated metal) on a second electrically conductive layer structure (e.g. second copper traces).

The first protective layer structure and the second protective layer structure (may be termed surface protection/finish layer structures) comprise: a) a common (in particular non-exposed) layer structure (e.g. immersion gold and/or ENEPIG), and b) different exposed layer structures (e.g. immersion gold and plated gold).

According to a second aspect of the invention, there is described a method of manufacturing a component carrier, the method comprising:
i) providing a component carrier pre-form (e.g. a panel) with a first exposed conductor area, comprising a first electrically conductive layer structure, and a second exposed conductor area, comprising a second electrically conductive layer structure,
ii) forming a common (non-exposed) layer structure (e.g. immersion gold and/or ENEPIG), as part of a first protective layer structure and as part of a second protective layer structure, on the first electrically conductive layer structure and on the second electrically conductive layer structure,
iii) covering the first exposed conductor area using a protection layer (e.g. a dry film), and (subsequently)
iv) forming a second exposed layer structure (e.g. plated gold) as part of the second protective layer structure, so that the second exposed layer structure is different from a first exposed layer structure of the first protective layer structure.

In the present context, the term "conductor area" may refer to a specific part/portion/region of the component carrier (preform), in particular when viewed along the vertical direction (z); in other words: from above. A first (surface) area may be defined as a first conductor area with first electrically conductive layer structures (e.g. copper traces). Further, a second (surface) area may be defined as a second conductor area with second electrically conductive layer structures (e.g. electric connections for a USB stick). In the present context, there may be a desire/need to provide (at least partially) different protection layer structures in the first conductor area and in the second conductor area.

In the present context, the term "exposed layer structure" may refer to a layer structure that is exposed at a (main) surface of a component carrier. The term "exposed" may hereby be relative term, meaning that the exposed layer structure is more exposed than non-exposed layer structures. The term "exposed layer structure" may in particular refer to the context of a protective (surface finish) layer structure. For example, a plated gold layer structure on top of an ENEPIG structure may be considered as an exposed layer structure. Further, an immersion gold layer (even if part of the ENEPIG structure) may be seen as the exposed layer structure. In an example, the term "exposed" may not necessarily mean that the layer structure is exposed directly to the environment. For example, an additional coating may be arranged on the exposed layer structure.

In the present context, the term "protective layer structure" may refer to a layer structure suitable to protect an electrically conductive layer structure, e.g. from corrosion and/or abrasion. The protective layer structure may be at least partially configured as a surface protection/finish material/layer structure (see detailed description above). Such a material may for example comprise ENEPIG, immersion gold, and/or plated gold and/or silver/and/or aluminium and/or tin. With such kind of structure, it does not only provide the protection for the electrically conductive layer, but also provide a layer structure for good soldering.

In the present context, the term "common, in particular non-exposed layer structure" may refer to at least one layer structure that is present in the first protective layer structure and in the second protective layer structure (for example ENEPIG and/or immersion gold). The term "non-exposed" may refer to the circumstance that said layer structure is not the exposed layer structure in the second protective layer structure (e.g. an immersion gold layer structure may be covered by a plated gold layer structure). Yet, in the first protective layer structure, the common layer structure may be exposed or non-exposed.

In the present context, the term "component carrier" may refer to a final component carrier product as well as to a component carrier preform (i.e. a component carrier in production, in other words a semi-finished product). In an example, a component carrier preform may be a panel that comprises a plurality of semi-finished component carriers that are manufactured together. At a final stage, the panel may be separated into the plurality of final component carrier products.

In an embodiment, the component carrier "stack" comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components. In an example, the stack may be nevertheless very thin and compact. In another example, the stack may be very thick for a high density product. The stacking direction (height/thickness) may be arranged in the vertical direction z. Further, the stacking direction may be perpendicular to the two directions of main extension (along x and y) of the (plate-shaped) component carrier.

In an example, all layers of the component carrier may form the stack. In another example, only a part of the layers of the component carrier form the stack. In this context, the term "layer structure" may in particular refer to a continuous or discontinuous layer (or separated islands within the same plane) of electrically conductive or electrically insulating material. A plurality of such layers, parallel stacked one upon the other, may form the stack in the vertical direction.

In the context of the present application, the term "main surface" of a body may particularly denote one of two largest opposing surfaces of the body or the outermost layer of the body. The main surfaces may be connected by circumferential side walls. The thickness of a body, such as a stack, may be defined by the distance between the two opposing main surfaces.

According to an exemplary embodiment, the invention may be based on the idea that a surface protection for exposed electrically conductive layer structures of a component carrier can be provided in an (cost-) efficient and robust manner, when a first exposed conductor area is covered by a first protective layer structure on a first electrically conductive layer structure, and a second exposed conductor area is covered by a second protective layer structure on a second electrically conductive layer structure, whereby the first protective layer structure and the second protective layer structure comprise a common non-exposed layer structure and different exposed layer structures.

In this manner, the manufacture process may be significantly shortened, while costs can be saved. In particular, a corresponding method may require only one protection layer (dry film) application, thereby omitting the second protection layer step (compare Figure 2A above). Further, due to the fast manufacture process, corrosion (e.g. of nickel) may be prevented/controlled.

### Exemplary Embodiments

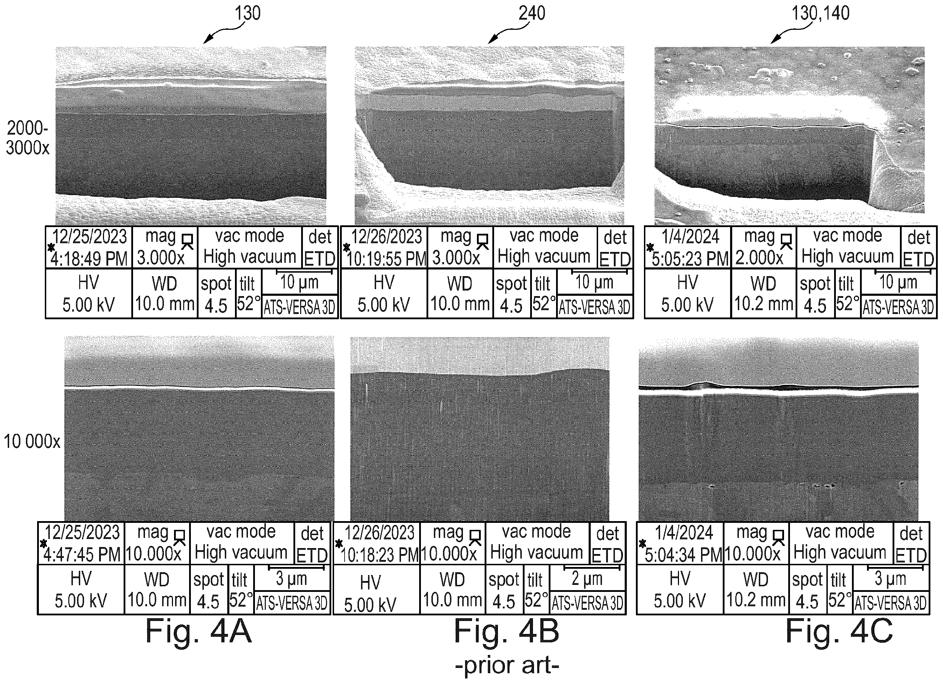

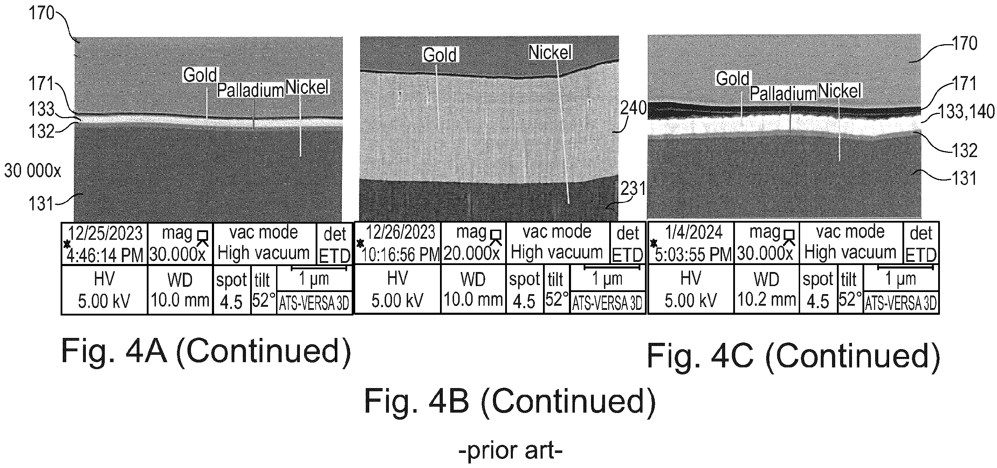

In an embodiment, the second exposed layer structure of the second protective layer structure is different from the first exposed layer structure of the first protective layer structure in at least one of material, physical properties, chemical properties, thickness. This may provide the advantage different exposed layer structures (in particular surface finishes) can be provided in a (cost-) efficient and reliable manner. In an embodiment, the second exposed layer structure comprises a plated gold layer structure, while the first exposed layer structure comprises an immersion gold layer structure. Even though both exposed layer structures comprise gold, the thickness may be significantly different (compare e.g. Figure 4), or the physical properties may be different (plated gold may also be termed hard gold), due to the different chemical and physical property of the different gold layers, the conductivity of the respective layer may be different since the different crystal texture and crystal lattice of the respective layer may impact the strength of metallic bond of the metal. The strength of metallic bond may influence the electron movement to result in the different conductivities. In this manner, different requirement can be met on the same component carrier.

In an embodiment, the second exposed layer structure of the second protective layer structure and/or the first exposed layer structure of the first protective layer structure comprises gold. Gold may be a well-suited material for a surface finish since gold may be very resistant against corrosion and/or abrasion. Gold may further comprise advantageous soldering properties.

In an embodiment, the second exposed layer structure of the second protective layer structure comprises plated (hard) gold. The plated gold layer structure may be more robust (in particular thicker) than the immersion gold layer structure, thereby providing a robust and reliable protection for critical electrically conductive layer structures. Besides, the plated gold layer structure may reach any desired thickness (in a controlled manner) by conventional plating process in a (cost-) efficient and reliable manner.

In an embodiment, the first exposed layer structure of the first protective layer structure comprises immersion gold. Thereby, a cost-efficient, robust, and established material may be provided as the exposed layer structure. Additionally, the immersion gold can be a base structure for the plating gold, the two gold layers can be bonding very tightly, or even become monolithic/integrated.

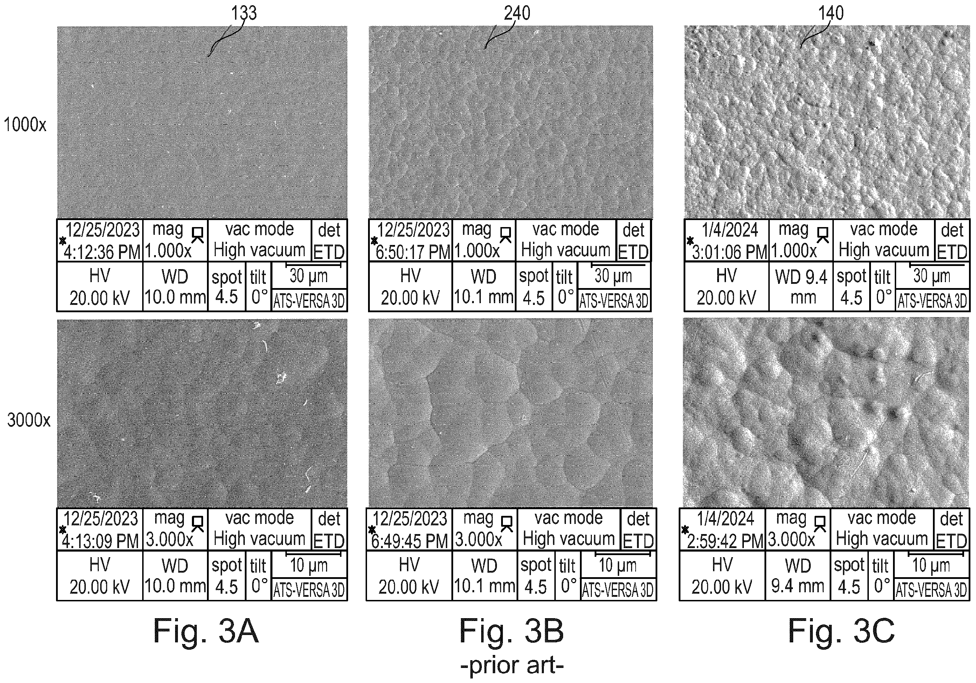

In an embodiment, the combination of plated gold (in other words hard gold) and immersion gold (in particular regarding the second protective layer structure) may result in a final product having a monolithic and especially thick gold layer. Nevertheless, as may be seen in Figures 3 and 4, an immersion gold layer structure and a plated gold layer structure may be distinguishable in the final component carrier product, e.g. using a microscope.

In an embodiment, the two gold layer structures (plated and immersion) penetrate into/with each other. There may be an interface or boundary region between the two layer structures, since the crystal texture of the two layers are different. In another example, there might be the situation that the immersion gold is an amorphous structure, while the plating gold is a crystal structure. With the penetration, the different structures may be emerging into each other; even the amorphous structure will be partially transferred into crystal structure. With this structure, the conductivity may be better than in the original structure.

In an embodiment, the common (not-exposed) layer structure and/or the different exposed layer structures is/are configured as a surface protection layer (in particular a surface finish). Thus, a plurality of layers may be used to protect the electrically conductive layer structures, eventually making the protection more robust.

In an embodiment, the common not-exposed layer structure comprises at least one of: a nickel-comprising layer structure, a palladium-comprising layer structure, an immersion gold layer structure. In an embodiment, wherein the common (not-exposed) layer structure comprises an ENIG layer structure or an ENEPIG layer structure. Thus, established and highly reliable component carrier materials may be directly applied. Such established surface finishes may display advantageous soldering and/or conductivity.

In an embodiment, the first protective layer structure comprises, in particular exclusively, an ENEPIG layer structure as a first surface protection layer. In an embodiment, the second protective layer structure comprises an ENEPIG layer structure and a plated gold layer structure as a second surface protection layer. In this preferred embodiment, both protective layer structures may share a common ENEPIG layer structure, while the second protective layer structure comprises an additional plated gold layer structure on top of the ENEPIG layer structure (so the exposed layer structures are different). The ENEPIG layer with the plated gold layer may improve the hardness more suitable, in particular for repeated plugging.

In an embodiment, the second exposed layer structure comprises cobalt, in particular a gold-cobalt alloy. This may reflect the manufacture step of plating, since a gold-cobalt alloy may be advantageous for the plating process. In particular, the cobalt may increase hardness and corrosion resistance. In an example, the amount of cobalt in the gold layer structure is around 0.3%.

In an embodiment, the first exposed layer structure is free of cobalt (because no plating process is used). Based on the presence of cobalt, it may be decided with respect to the final component carrier product, if a gold layer structure has been manufactured by an immersion process or a plating process.

In an embodiment, a roughness of an exposed surface of the second exposed layer structure, in particular (on top of) the plated gold, is higher than a roughness of an exposed surface of the first exposed layer structure, in particular on (top of) the first ENEPIG layer structure. The surface roughness may be observed using a microscope, see e.g. Figure 3, so that these (gold) layer structures may be clearly distinguished. The surface roughness may be a structural feature that reflects a specific manufacture process.

In an embodiment, the material of an exposed surface of the second exposed layer structure, in particular (on top of) the plated gold, is crystallized and/or textured. In an embodiment, the material of an exposed surface of the first exposed layer structure, in particular (on the top of) the first ENEPIG layer structure, is uniform. The texture/crystallinity may be observed using a microscope, see e.g. Figure 3, so that these (gold) layer structures may be clearly distinguished in the final product.

The difference between the crystallized and/or textured structure of the exposed surface of the second exposed layer structure and the uniform structure of the exposed surface of the first exposed layer structure may be considered as the footprint of the manufacturing method of the claimed component carrier.

In an embodiment, the abrasion properties of an exposed surface of the second exposed layer structure, in particular (on top of) the plated gold, are higher than the abrasion properties of an exposed surface of the first exposed layer structure, in particular (on the top of) the first ENEPIG layer structure. Thus, the second exposed layer structure may be more robust and provide a better protection. Further, based on the abrasion properties, the exposed layer structures may be clearly distinguished in the final product.

In an embodiment, a thickness of the second exposed layer structure, in particular (on top of) the plated gold, is significantly higher, in particular five times or more, than the thickness of the first exposed layer structure, in particular (on the top of) the first ENEPIG layer structure. Thus, the second exposed layer structure may be more robust and provide a better protection. Further, based on the thickness, the exposed layer structures may be clearly distinguished in the final product.

In an embodiment, the vertical position of the second exposed layer structure is different, in particular higher (or lower), than the vertical position of the first exposed layer structure. In particular, the second conductor area may comprise at least one more layer than the first conductor area or at least one layer in the second conductor area is thicker than layers in the first conductor area. The thicker second protective layer structure may thus lead to a better protection, yet, costs may be saved when making the first protective layer structure only as robust as required.

In an embodiment, the second exposed conductor area is associated with a wire bonding area and/or a goldfinger area (e.g. electric contacts of a connector such as a USB stick). Such areas may require an especially reliable protection. Using the present disclosure, such economically and technically important applications may be realized in an efficient and robust manner.

In an embodiment, the second non-exposed layer structure of the second protective layer structure is common to the first non-exposed layer structure of the first protective layer structure in at least one of material, physical properties, chemical properties, thickness. In particular, the common layer structure may be (essentially) identical. This may provide the advantage that at least one layer structure may be provided for both, the first conductor area and the second conductor area, in a common process step, thereby saving costs and efforts.

In an embodiment, the component carrier further comprises:
a solder resist layer structure on the first electrically conductive layer structure and/or on the second electrically conductive layer structure. In particular, the solder resist layer structure comprises at least one opening, therein exposing the first electrically conductive layer structure and/or the second electrically conductive layer structure. Further elements such as components may be mounted to the exposed first electrically conductive layer structure and/or the exposed second electrically conductive layer structure. This may provide the advantage that the electrically conductive layer structure without the protection layer structure of the component carrier is protected in a robust manner.

In an embodiment, the electrically conductive layer structure, which is not covered by the protection layer structure, is covered/protected by a solder resist layer structure. In this manner, the electrically conductive layer structure, which is not covered by the protection layer structure, is protected efficiently and reliably by the solder resist layer structure.

In an embodiment of the method, forming the second exposed layer structure comprises plating, in particular gold plating. Using plating, an especially robust protection layer structure may be provided using established component carrier manufacture techniques.

In an embodiment, the method comprises: removing the protection layer to expose the first exposed layer structure. Hence, only one protection layer may be required for the manufacture process, thereby saving time and efforts.

In an embodiment of the method, forming the common non-exposed layer structure comprises: forming an immersion gold layer structure, in particular as part of an ENEPIG layer structure.

In an embodiment, one or more further elements (e.g. an (electronic) component may be mounted to the exposed layer structure. This may provide the advantage that this protected region may be efficiently used for further functionalities.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semiconducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS2, CuGaO2, AgAlO2, LiGaTe2, AgInSe2, CuFeS2, BeO.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure (and/or the curable dielectric elements) comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE), polyvinylidene fluoride (PVDF) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, carbon, platinum, (doped) silicon, and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically nonconductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al2O3) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above and further aspects of the invention are apparent from the examples of embodiment to be described hereinafter and are explained with reference to these examples of embodiment.
Figure 1A shows a method of manufacturing a component carrier, Figure 1B shows a cross-section through a second exposed conductor area, and Figure 1C shows a cross-section through a first exposed conductor area, according to exemplary embodiments of the invention.
Figure 2A shows a conventional method of manufacturing a component carrier, and Figure 2B shows a cross-section through a corresponding component carrier.
Figures 3A to 3C show a comparison of microscopic images of exposed surfaces of protective layer structures, according to exemplary embodiments of the invention.
Figures 4A to 4C show a comparison of microscopic images of cross-sections through protective layer structures, according to exemplary embodiments of the invention.
Figures 5A to 5C show a comparison of elemental analyses of protective layer structures, according to exemplary embodiments of the invention

### Detailed Description of the Drawings

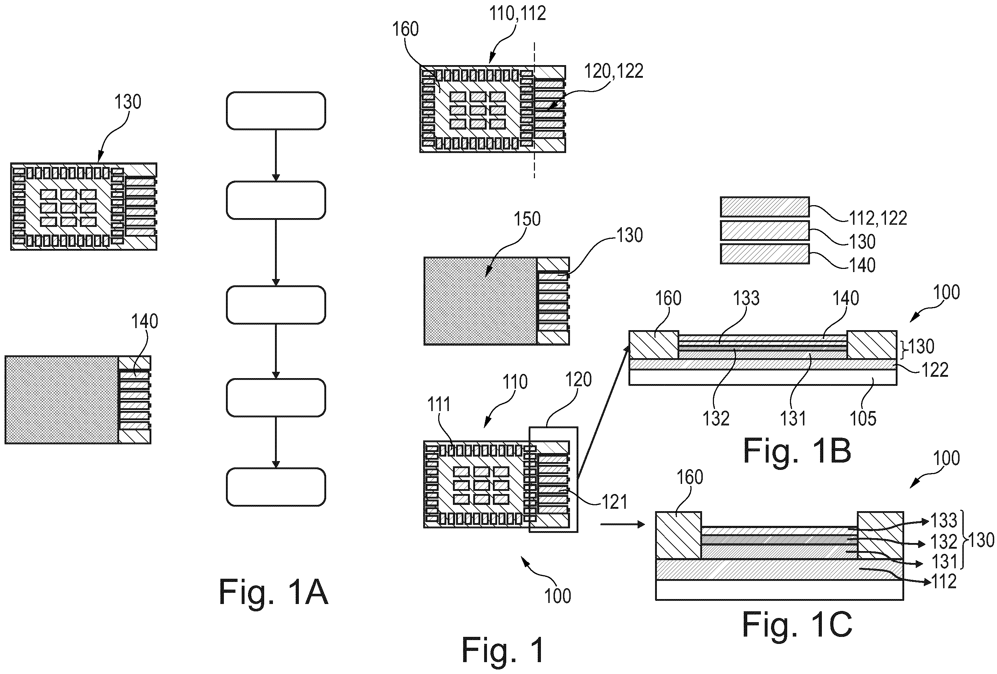

**Figure 1A** shows a method of manufacturing a component carrier 100, according to an exemplary embodiment of the invention. In the first place, there is provided a component carrier pre-form with a first exposed conductor area 110, comprising a first electrically conductive layer structure 112, and a second exposed conductor area 120, comprising a second electrically conductive layer structure 122. Both electrically conductive layer structures 112, 122 are covered by a solder resist layer structure 160, wherein said solder resist layer structure 160 comprises a plurality of openings exposing the electrically conductive layer structures 112, 122 arranged below the solder resist layer structure 160.

A common (non-exposed) layer structure 130 is formed as part of a first protective layer structure 111 and as part of a second protective layer structure 121 on the first electrically conductive layer structure 112 and on the second electrically conductive layer structure 122, respectively. In other words, all exposed (not covered by the solder resist layer structure 160) electrically conductive layer structures 112, 122 are covered by the same common (protective) layer structure 130.

Then, the first exposed conductor area 110 is selectively covered using a protection layer 150 (e.g. a dry film or other conformal mask, please note that this method applies only one protection layer 150).

Subsequently, a second exposed layer structure 140 is formed selectively on the second electrically conductive layer structure 122 as part of the second protective layer structure 121, so that the second exposed layer structure 140 is different from a first exposed layer structure 133 of the first protective layer structure 111. The second exposed layer structure 140 is hereby formed by a plating process. Finally, the protection layer 150 is stripped.

**Figure 1B** shows a cross-section through a second exposed conductor area 120 of a component carrier 100, according to an exemplary embodiment of the invention. The second electrically conductive layer structure 122 (e.g. patterned copper layer) is arranged on an electrically insulating stack material, e.g. prepreg, layer 105. On top of the second electrically conductive layer structure 122, there is arranged a solder resist layer structure 160 that comprises said opening for exposing the second electrically conductive layer structure 122 arranged below the solder resist layer structure 160. The exposed second electrically conductive layer structure 122 is covered here by a nickel-comprising layer structure 131, a palladium-comprising layer structure 132, and an immersion gold layer structure 133. These three layer structures 131, 132, 133 form together the layer stack of an ENEPIG structure as the common (here not exposed) layer structure 130.

On top of said common layer structure 130, there is provided the additional plated gold layer structure 140 (second/different exposed layer structure 140). The plated gold layer structure 140 can be arranged with respect to the solder resist layer structure 160 regarding the vertical height/level as follows: higher or lower or flush.

**Figure 1C** shows a cross-section through a first exposed conductor area 110 of a component carrier 100, according to an exemplary embodiment of the invention. The first exposed conductor area 110 does not comprise the plated gold layer 140, but only the three layers 131, 132, 133 that constitute the common ENEPIG structure 130. In this example, a free space remains, where in Figure 1B the plated gold layer 140 is arranged. Comparing the examples of Figures 1B and 1C, the exposed layer structures 133, 140 are different from each other. The immersion gold layer structure 133 can be arranged with respect to the solder resist layer structure 160 regarding the vertical height/level as follows: higher or lower or flush; hereby "lower" may be preferable.

**Figures 3A to 3C** show a comparison of microscopic images of exposed surfaces of protective layer structures 130, 140, according to exemplary embodiments of the invention. While the upper three images show a magnification of 1000x, the lower three images show a magnification of 3000x.

Figure 3A shows the surface of an immersion gold layer structure 133 (uppermost layer of the ENEPIG structure 130) of the first exposed conductor area 110. It can be seen that the surface is rather smooth.

Figure 3B shows a conventional surface of pure (gold) plating (compare Figure 2B). The surface is rougher compared to Figure 3A.

Figure 3C shows the surface of a plated gold layer structure 140 (on top of an ENEPIG structure 130) of the second exposed conductor area 120. The surface is significantly rougher than in case of Figure 3B.

**Figures 4A to 4C** show a comparison of microscopic images of cross sections through protective layer structures, according to exemplary embodiments of the invention. While the upper three images show a magnification of 2000-3000x, the middle three images show a magnification of 10000x, and the lower three images show a magnification of 30000x (Figure 4B is 20000x).

Figure 4A shows a cross-section through the first exposed conductor area 110. The following layers can be seen from bottom to top: nickel-comprising layer structure 131, palladium-comprising layer structure 132, immersion gold layer structure 133, a free space 171, and a further conductive coating 170. The free space 171 exists because the surface of the component carrier and the further coating 170 are not tightly attached to each other. The further conductive coating is only added for the microscopic investigation (to avoid electrostatics).

Figure 4B shows a cross-section through a conventional pure plating structure (compare Figure 2B). The plated nickel layer structure 231 is covered by the plated gold layer structure 240. It can be seen that the thickness of the plated gold layer structure 240 is higher than the immersion gold layer structure 133 of Figure 4A, as the plated gold layer structure 240 may reach any desired thickness by conventional plating process, in an (cost-) efficient way. A free space 171, and a further conductive coating 170 can also be seen.

Figure 4C shows a cross-section through a second exposed conductor area 120. The following layers can be seen from bottom to top: nickel-comprising layer structure 131, palladium-comprising layer structure 132, immersion gold layer structure 133, plated gold layer structure 140, a free space 171, and a further conductive coating 170. It can be seen in the real cross-section that the immersion gold layer structure 133 and the plated gold layer structure 140 cannot be visually well-distinguished (they look like a uniform and crystallized/textured structure). It should also be noted that the plated gold layer structure 140 may reach any desired thickness by conventional plating process, in an (cost-) efficient way, even if it looks thinner than the plated gold layer structure 240 of Figure 4B.

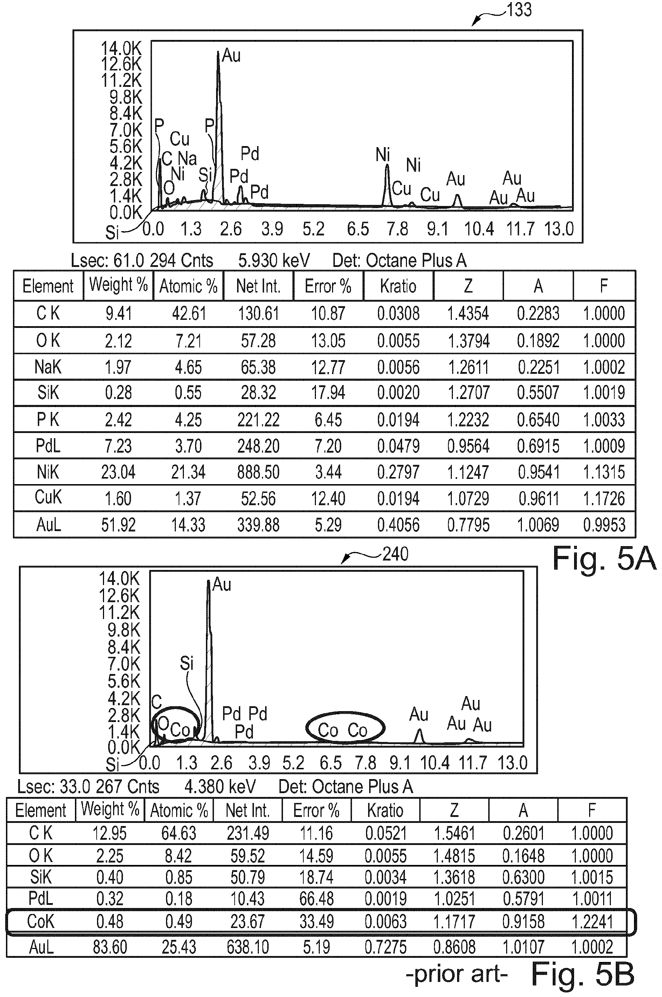

**Figures 5A to 5C** show a comparison of elemental analyses of protective layer structures, according to exemplary embodiments of the invention. The elemental analyses correspond respectively to the layer structures shown in Figures 3A to 3C. The elemental analyses have been done by EDX (energy-dispersive X-ray spectroscopy).

Figure 5A: the immersion gold layer structure 133 (of an ENEPIG structure) comprises mainly gold. Nickel is present but no cobalt.

Figure 5B: the conventional plated gold layer structure 240 comprises gold and also cobalt.

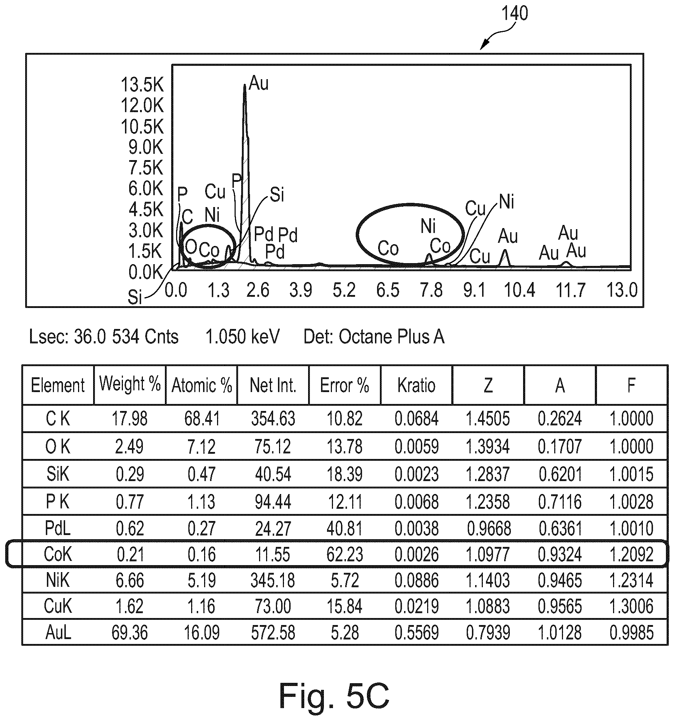

Figure 5C: for the plated gold layer structure 140 it can also be seen that cobalt is present besides gold.

Accordingly, the presence of cobalt may indicate a manufacture step of plating. This may be due to the fact that a gold-cobalt alloy (around 0.3% cobalt) can be applied. Cobalt may increase hardness and corrosion resistance. Thereby, the immersion gold layer structure 133 and the plated gold layer structure 140 may be clearly distinguished.

### Reference signs

- 100: Component carrier
- 105: Electrically insulating layer structure
- 110: First exposed conductor area
- 111: First protective layer structure
- 112: First electrically conductive layer structure
- 120: Second exposed conductor area
- 121: Second protective layer structure
- 122: Second electrically conductive layer structure
- 130: Common not-exposed layer structure, ENEPIG layer structure
- 131: Nickel-comprising layer structure
- 132: Palladium-comprising layer structure
- 133: First exposed layer structure, immersion gold layer structure
- 140: Different exposed layer structure, second exposed layer structure, plated gold layer structure
- 150: Protective layer/film
- 160: Solder resist/mask
- 170: Conductive coating
- 171: Free space

## Claims

1. A component carrier (100), comprising:
a first exposed conductor area (110), comprising a first protective layer structure (111) on a first electrically conductive layer structure (112); and
a second exposed conductor area (120), comprising a second protective layer structure (121) on a second electrically conductive layer structure (122);
wherein the first protective layer structure (111) and the second protective layer structure (121) comprise:
a common layer structure (130); and
different exposed layer structures (133, 140).

2. The component carrier (100) of claim 1,
wherein the second exposed layer structure (140) of the second protective layer structure (121) is different from the first exposed layer structure (133) of the first protective layer structure (111) in at least one of material, physical properties, chemical properties, thickness.

3. The component carrier (100) of claim 1 or 2,
wherein the second exposed layer structure (140) of the second protective layer structure (121) and/or the first exposed layer structure (133) of the first protective layer structure (111) comprises gold, in particular wherein the second exposed layer structure (140) of the second protective layer structure (121) comprises plated gold; and/or wherein the first exposed layer structure (133) of the first protective layer structure (111) comprises immersion gold.

4. The component carrier (100) according to one of the preceding claims, wherein the common not-exposed layer structure (130) and/or the different exposed layer structures (133, 140) is/are configured as a surface protection layer.

5. The component carrier (100) according to one of the preceding claims, wherein the common not-exposed layer structure (130) comprises at least one of:
a nickel-comprising layer structure (131),
a palladium-comprising layer structure (132),
an immersion gold layer structure (133);
and/or
wherein the common not-exposed layer structure (130) comprises an ENIG layer structure or an ENEPIG layer structure.

6. The component carrier (100) according to one of the preceding claims, wherein the first protective layer structure (111) comprises, in particular exclusively, an ENEPIG layer structure (130) as a first surface protection layer; and/or
wherein the second protective layer structure (121) comprises an ENEPIG layer structure (130) and a plated gold layer structure (140) as a second surface protection layer.

7. The component carrier (100) according to one of the preceding claims, wherein the second exposed layer structure (140) comprises cobalt, in particular a gold-cobalt alloy; and/or
wherein the first exposed layer structure (133) is free of cobalt.

8. The component carrier (100) according to one of the preceding claims,
wherein a roughness of an exposed surface of the second exposed layer structure (140), in particular on top of the plated gold (140), is higher than a roughness of an exposed surface of the first exposed layer structure (133), in particular on the top of the first ENEPIG layer structure (130).

9. The component carrier (100) according to one of the preceding claims,
wherein the material of an exposed surface of the second exposed layer structure (140), in particular on top of the plated gold (140), is crystallized and/or textured; and/or
wherein the material of an exposed surface of the first exposed layer structure (133), in particular on the top of the first ENEPIG layer structure (130), is uniform.

10. The component carrier (100) according to one of the preceding claims,
wherein a thickness of the second exposed layer structure (140), in particular on top of the plated gold (140), is significantly higher, in particular five times or more, than the thickness of the first exposed layer structure (133), in particular on the top of the first ENEPIG layer structure (130).

11. The component carrier (100) according to one of the preceding claims,
wherein the second exposed conductor area (120) is associated with a wire bonding area and/or a goldfinger area.

12. The component carrier (100) according to one of the preceding claims, further comprising:
a solder resist layer structure (160) on the first electrically conductive layer structure (112) and/or on the second electrically conductive layer structure (122),
wherein the solder resist layer structure (160) comprises at least one opening, therein exposing the first electrically conductive layer structure (112) and/or the second electrically conductive layer structure (122).

13. A method of manufacturing a component carrier (100), wherein the method comprises:
providing a component carrier pre-form with a first exposed conductor area (110), comprising a first electrically conductive layer structure (112), and a second exposed conductor area (120), comprising a second electrically conductive layer structure (122);
forming a common layer structure (130), as part of a first protective layer structure (111) and as part of a second protective layer structure (121), on the first electrically conductive layer structure (112) and on the second electrically conductive layer structure (122);
covering the first exposed conductor area (110) using a protection layer; and
forming a second exposed layer structure (140) as part of the second protective layer structure (121), so that the second exposed layer structure (140) is different from a first exposed layer structure (133) of the first protective layer structure (111).

14. The method according to claim 13,
wherein forming the second exposed layer structure (140) comprises plating, in particular gold plating.

15. The method according to one of claims 13 or 14,
wherein forming the common non-exposed layer structure (130) comprises:
forming an immersion gold layer structure (133), in particular as part of an ENEPIG layer structure (130).
